(19) Europäisches Patentamt / European Patent Office / Office européen des brevets

(11) **EP 1 873 905 A1**

(12) **DEMANDE DE BREVET EUROPEEN**

(43) Date de publication:
**02.01.2008 Bulletin 2008/01**

(51) Int Cl.:
***H03D 7/14*** *(2006.01)*

(21) Numéro de dépôt: **07110347.7**

(22) Date de dépôt: **15.06.2007**

(84) Etats contractants désignés:
**AT BE BG CH CY CZ DE DK EE ES FI FR GB GR HU IE IS IT LI LT LU LV MC MT NL PL PT RO SE SI SK TR**
Etats d'extension désignés:
**AL BA HR MK YU**

(30) Priorité: **20.06.2006 FR 0605496**

(71) Demandeur: **STMICROELECTRONICS SA**
**92120 Montrouge (FR)**

(72) Inventeurs:
• **Belot, Didier**
  **38140, RIVES (FR)**

• **Svelto, Francesco**
  **27100, PAVIA (IT)**
• **Sosio, Marco**
  **23037, TIRANO (Sondrio) (IT)**
• **Brandolini, Massimo**
  **27050, REDAVALLE (Pavia) (IT)**

(74) Mandataire: **Delprat, Olivier et al**
  **Bureau Casalonga & Josse**
  **Bayerstrasse 71/73**
  **80335 München (DE)**

(54) **Amplificateur mélangeur et circuit frontal radiofréquence pourvu d'un tel amplificateur mélangeur.**

(57)     Cet amplificateur mélangeur comprend un étage d'amplification (3) et un étage mélangeur (4) servant conjointement à amplifier un signal incident et à transposer la fréquence dudit signal vers une fréquence prédéterminée.

L'étage d'amplification comprend au moins un circuit source de courant (T1, T2).

En outre, il comprend un filtre bouchon (B) adapté pour modifier le courant circulant dans le circuit source de courant.

Fig.2

EP 1 873 905 A1

**Description**

L'invention concerne les circuits frontaux notamment pour appareils de télécommunication et se rapporte plus particulièrement à un amplificateur mélangeur pour des tels circuits.

Les amplificateurs mélangeurs sont des composants essentiels de tous les émetteurs et récepteurs fonctionnant aux hyperfréquences.

En effet, les mélangeurs sont utilisés dans la plupart des systèmes de communication, et en particulier dans les postes de télécommunication de type postes téléphoniques cellulaires pour transposer en fréquence un signal sans modifier l'information dont il est porteur.

En particulier, à l'émission, les mélangeurs sont utilisés pour transposer en hyperfréquences un signal utile à émettre délivré à une fréquence intermédiaire. Inversement, en réception, ils sont utilisés pour transposer la fréquence RF d'un signal reçu vers une fréquence intermédiaire relativement basse afin de pouvoir être traité par des circuits électroniques avals.

On distingue ainsi deux modes de fonctionnement pour le mélangeur, d'une part dans le sens montant, à l'émission, qui correspond à la transposition de la fréquence du signal traité de la fréquence intermédiaire FI vers les hautes fréquences et, d'autre part, dans le sens descendant, à la réception, qui correspond à la transposition de la fréquence RF vers la fréquence intermédiaire FI.

Il existe à ce jour divers types d'amplificateurs mélangeurs permettant d'obtenir un tel comportement.

Toutefois, les circuits actifs pour la réalisation de circuits frontaux, également désignés par les anglo-saxons par le terme de « Front End Circuits », sont avantageux dans la mesure où ils permettent d'obtenir une intégration très compacte.

Toutefois, les circuits actifs présentent des performances en bruit et en linéarité relativement médiocres. En particulier, le mélangeur requiert, à la réception, des performances élevées en termes de linéarité et de bruit.

A cet égard, la linéarité d'ordre 2 d'un amplificateur mélangeur, qui est définie par le point d'interception de la tangente de la puissance d'entrée à la première harmonique avec la tangente de la puissance d'entrée à la deuxième harmonique, dans leurs zones linéaires, et qui qualifie la pureté spectrale de l'amplificateur mélangeur est un paramètre qui doit être maîtrisé.

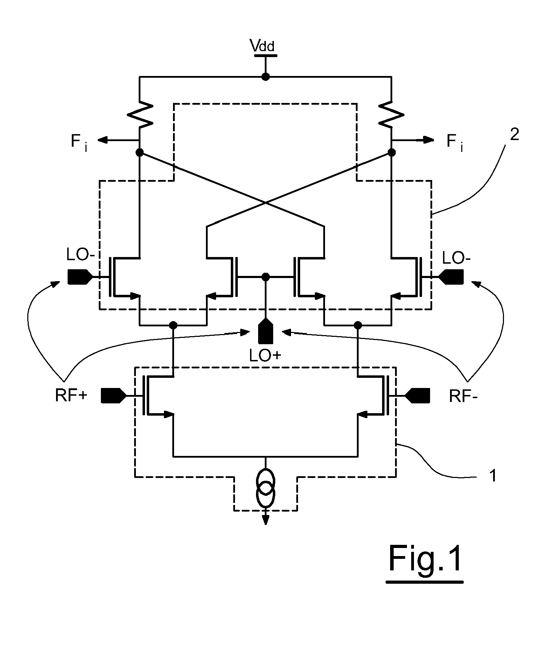

On a représenté sur la figure 1 la structure générale d'un amplificateur mélangeur selon l'état de la technique.

Comme on le voit sur cette figure, un amplificateur mélangeur conventionnel comprend essentiellement un étage d'amplification 1 et un étage mélangeur 2 servant conjointement, selon le mode de fonctionnement du circuit frontal radiofréquence auquel il est intégré, soit à décaler la fréquence du signal utile de la bande de base vers les hautes fréquences, à l'émission, soit à décaler la haute fréquence du signal utile reçu vers la bande de base pour être ultérieurement traité, à la réception.

Un homme du métier reconnaîtra que l'amplificateur mélangeur illustré à la figure 1 correspond à un mélangeur de type à cellules de Gilbert.

Comme on le voit sur cette figure, un mélangeur possède deux accès pour les fréquences utiles, à savoir pour la fréquence intermédiaire FI et pour la radiofréquence RF, et un accès pour un signal de référence issu d'un oscillateur local LO auquel est multiplié le signal d'entrée. Après multiplication du signal d'entrée et du signal issu de l'oscillateur local, deux nouvelles fréquences sont générées, constituées l'une par la somme des fréquences du signal d'entrée et du signal de référence, et l'autre par la différence entre ces deux fréquences. En fonction du mode de fonctionnement à obtenir, on peut sélectionner, par filtrage, soit la fréquence haute, soit la fréquence basse, afin d'éliminer la composante fréquentielle qui n'intéresse pas la conversion mise en jeu.

Comme indiqué précédemment, un amplificateur mélangeur à cellules de Gilbert présente des performances en linéarité relativement médiocres.

En particulier, la linéarité d'ordre 2 ou IIP2 (« Input Interception Point 2 »), est relativement médiocre.

En outre, comme illustré par les flèches F, aux fréquences mises en jeu, il existe un couplage entre les ports d'entrée à haute fréquence et le port d'entrée pour le signal de référence issu de l'oscillateur local.

On retrouve également un couplage entre le port pour le signal utile à fréquence intermédiaire et le port pour le signal de l'oscillateur local, ainsi qu'un couplage entre le port pour le signal utile à fréquence intermédiaire et pour le signal utile à haute fréquence RF. Ces couplages induisent un mélange des signaux, en particulier en raison du couplage entre le port à hautes fréquences RF et le port de l'oscillateur local.

Enfin, ce type de mélangeur est le siège de fuites dans les transistors entrant dans la constitution du mélangeur. Ces fuites tendent à engendrer un déséquilibre qui est susceptible de favoriser un multiple d'une fréquence.

Au vu de ce qui précède, le but de l'invention est de pallier les inconvénients liés aux amplificateurs mélangeurs conventionnels et, en particulier, de fournir un amplificateur mélangeur présentant une pureté spectrale améliorée et, en particulier, une linéarité spectrale d'ordre 2 la plus grande possible.

L'invention a donc pour objet un amplificateur mélangeur, en particulier pour circuit frontal radiofréquence d'un appareil de télécommunication, comprenant un étage d'amplification et un étage mélangeur servant conjointement à amplifier un signal incident et à transposer la fréquence du signal vers une fréquence prédéterminée, l'étage d'amplification comprenant au moins un circuit source de courant.

Cet amplificateur mélangeur se caractérise en ce qu'il comprend un filtre bouchon adapté pour modifier le courant circulant dans le circuit source de courant.

Ainsi, lorsqu'un déséquilibre apparaît au sein de l'amplificateur mélangeur, et en particulier entre deux branches d'une cellule de Gilbert, le filtre bouchon est en mesure, par appel de courant, de modifier le comportement de l'amplificateur mélangeur et, en particulier, de réduire les harmoniques d'ordre 2 engendrés et amplifiés par l'étage d'amplification.

Ainsi, par exemple, l'étage mélangeur et l'étage d'amplification sont avantageusement réalisés sous la forme d'une paire de cellules en parallèle, le filtre bouchon pouvant alors être disposé entre les deux cellules en parallèle.

Selon une autre caractéristique de l'invention, le filtre bouchon comporte des moyens pour détecter un déséquilibre entre les deux cellules et une source de courant qui est connectée auxdites cellules et qui est pilotée par les moyens pour détecter le déséquilibre de manière à modifier le courant circulant dans chaque cellule.

Selon encore une autre caractéristique de l'invention, la source de courant est raccordée à chaque cellule par une inductance.

On peut encore utiliser un condensateur pour raccorder à la masse le noeud commun entre la source de courant et les inductances.

Dans un mode de réalisation, les moyens pour détecter le déséquilibre entre les deux cellules de l'amplificateur mélangeur comportent un comparateur dont l'une des bornes inverseuse et non inverseuse reçoit un niveau de potentiel prélevé entre les deux cellules et dont l'autre borne reçoit un seuil de tension de détection de déséquilibre.

Par exemple, les deux cellules étant reliées par une branche du circuit pourvue de deux résistances identiques, ledit niveau de tension étant constitué par le niveau de tension prélevé sur le noeud commun entre les deux résistances.

Par exemple, l'amplificateur mélangeur est réalisé à partir d'une cellule de Gilbert, de préférence une cellule de Gilbert doublement équilibrée.

L'invention a également pour objet, selon un deuxième aspect, un circuit frontal radiofréquence pour appareil de télécommunication, comprenant un amplificateur mélangeur tel que défini ci-dessus.

D'autres buts, caractéristiques et avantages de l'invention apparaîtront à la lecture de la description suivante, donnée uniquement à titre d'exemple non limitatif, et faite en référence aux dessins annexés sur lesquels :

- la figure 1, dont il a déjà été fait mention, illustre la structure générale d'un amplificateur mélangeur conventionnel ; et
- la figure 2 est un schéma synoptique d'un amplificateur mélangeur selon l'invention.

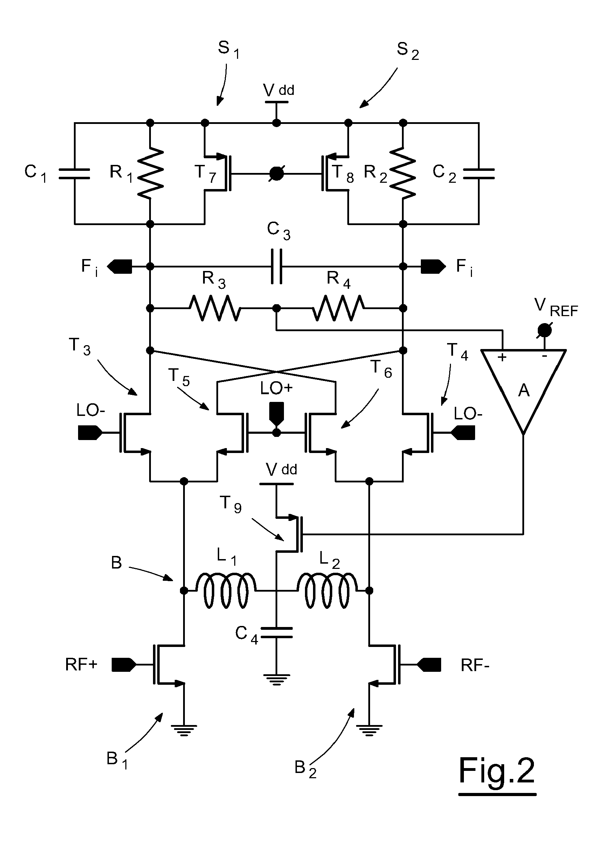

En référence à la figure 2, l'amplificateur mélangeur selon l'invention comprend un étage d'amplification 3 et un étage mélangeur 4.

Par exemple, ce circuit est destiné à être incorporé à un circuit frontal radiofréquence d'un poste de télécommunication tel qu'un poste téléphonique mobile. En fonction du mode de fonctionnement du circuit frontal, l'amplificateur mélangeur est destiné à convertir en hyperfréquences la fréquence d'un signal utile élaboré par des circuits de téléphonie à une fréquence intermédiaire FI comprise dans une bande de base ou, à la réception, pour transposer vers la fréquence intermédiaire FI la fréquence d'un signal radiofréquence incident afin de permettre un traitement ultérieur de signal par des circuits de traitement aval.

En d'autres termes, le principe du mélangeur est de procéder à un décalage en fréquence d'un signal par un signal d'un oscillateur local LO, vers le haut, à l'émission, ou vers le bas à la réception.

En particulier, après multiplication du signal par le signal issu de l'oscillateur local, le signal converti issu du mélangeur se présente sous la forme :

$$\frac{1}{2} AB \left[ Cos(\omega_{RF} - \omega_{OL})t + Cos(\omega_{RF} + \omega_{OL})t \right]$$

dans laquelle :

- A et B désignent respectivement l'amplitude du signal utile à convertir et l'amplitude du signal de l'oscillateur local ; et
- $\omega_{RF}$ et $\omega_{OL}$ désignent la pulsation du signal utile et du signal de l'oscillateur local.

Par filtrage, en fonction du mode de fonctionnement du circuit frontal, on privilégie soit la composante Cos

($\omega_{RF}-\omega_{OL}$) t, à la réception, soit la composante Cos ($\omega_{RF} + \omega_{OL}$) t, à l'émission.

Comme on le voit sur la figure 2, l'amplificateur mélangeur est de type à cellules de Gilbert et comporte deux cellules constituant deux branches B1 et B2 symétriques disposées en parallèle.

En ce qui concerne l'étage d'amplification 3, celui-ci est constitué par l'association de deux transistors NMOS T1 et T2 dont la grille reçoit les signaux hyperfréquence RF+ et RF-, dont la source est raccordée à la masse et dont le drain est relié à l'étage mélangeur 4.

Comme cela sera décrit en détail par la suite, les transistors MOS T1 et T2 constituent des circuits source de courant qui sont destinés, en fonctionnement, à être couplés à des sources de courant complémentaire S1 et S2 de l'étage mélangeur.

En ce qui concerne cet étage mélangeur, celui-ci comporte essentiellement deux paires de transistors NMOS fonctionnant en régime de commutation.

La grille d'un premier transistor T3 et T4, respectivement, de chaque paire, reçoit un signal LO- d'un oscillateur local, tandis que sa source est raccordée au drain d'un transistor T1 ou T2 correspondant de l'étage d'amplification 3, et son drain est raccordé, d'une part, à un circuit source de courant correspondant et d'autre part à une borne de sortie ou d'entrée du signal FI à fréquence intermédiaire.

Chaque paire est également pourvue d'un deuxième transistor NMOS T5 ou T6 dont la source est raccordée à la source du premier transistor T3 ou T4, dont le drain est raccordé au drain du premier transistor T3 ou T4 de l'autre paire, et dont la grille reçoit un signal de l'oscillateur local LO+.

Les circuits source de courant S1 et S2 de chaque étage mélangeur sont réalisés à partir d'une paire de transistors PMOS T7 et T8 dont la source S est connectée à une source de tension continue $V_{dd}$ et dont le drain est raccordé au drain des premiers transistors T3 et T4 de chaque paire de transistors de l'étage mélangeur 4.

On voit également sur la figure 2 que les grilles des deux transistors T7 et T8 sont raccordées, tandis que des résistances de charge R1 et R2 associées à des condensateurs de filtrage C1 et C2 sont connectées en parallèle entre la source et le drain de chaque transistor T7 et T8.

Dans le but d'améliorer la pureté spectrale de l'amplificateur mélangeur et, en particulier, d'obtenir une linéarité spectrale d'ordre 2 la plus grande possible, en réduisant les harmoniques d'ordre 2, l'amplificateur mélangeur est pourvu d'un filtre bouchon B interposé entre les deux branches B1 et B2.

Ce filtre bouchon B est associé à des moyens pour mesurer le déséquilibre entre les deux branches B1 et B2.

Pour ce faire, un pont diviseur, constitué par l'association en série de deux résistances R3 et R4 est disposé entre les deux branches B1 et B2, au sein de l'étage mélangeur.

Un condensateur C3 est placé en parallèle sur les deux résistances R3 et R4.

Le noeud commun entre les deux résistances R3 et R4 est raccordé à la borne non inverseuse d'un amplificateur opérationnel A, dont la borne inverseuse reçoit une tension de référence $V_{ref}$ de contrôle.

La sortie de l'amplificateur opérationnel A est raccordée à la grille d'un transistor PMOS T9 formant source de courant dont la source S est raccordée à une source de tension continue $V_{dd}$.

Enfin, le filtre est pourvu de deux inductances L1 et L2 disposées en série entre les deux branches B1 et B2 et d'un condensateur C4 optionnel, dont la fonction est essentiellement d'augmenter la dynamique des transistors RF T1 et T2. Le noeud commun entre les deux inductances L1 et L2 est raccordé au drain du transistor T9.

On notera que les résistances R3 et R4 de mesure de déséquilibre entre les branches B1 et B2 ont une valeur relativement élevée, de l'ordre de 10 kΩ. Par exemple, le condensateur C3 connecté en parallèle sur ces résistances a une valeur de l'ordre de 520 pF. On crée ainsi un filtre passe-haut permettant de réduire le bruit en 1/f de l'amplificateur mélangeur. Lorsque les deux branches B1 et B2 sont parfaitement équilibrées, la tension prélevée par la borne non inverseuse de l'amplificateur opérationnel A est nulle. Au contraire, en cas de déséquilibre, cette tension s'élève. Dans le cas où elle devient supérieure à la tension de référence $V_{ref}$, traduisant un déséquilibre entre les branches B1 et B2 et une différence de courant consécutive entre ces deux branches B1 et B2, la sortie de cet amplificateur pilote le transistor TNP T9, ce qui provoque l'injection d'un courant dans les branches B1 et B2 de manière à solliciter les transistors T7 ou T8 des circuits source de courant et à ramener ainsi les deux branches à l'équilibre.

On conçoit donc que l'invention permet un maintien de l'équilibre entre les deux branches B1 et B2 en prévoyant une contre-réaction au sein de l'amplificateur mélangeur.

**Revendications**

1. Amplificateur mélangeur, en particulier pour circuit frontal radiofréquence d'un appareil de télécommunication, comprenant un étage d'amplification (3) et un étage mélangeur (4) servant conjointement à amplifier un signal incident et à transposer la fréquence dudit signal vers une fréquence prédéterminée (FI), l'étage d'amplification (3) comprenant au moins un circuit (T1, T2) source de courant, **caractérisé en ce qu'**il comprend un filtre bouchon (B) adapté pour modifier le courant circulant dans le circuit source de courant.

**2.** Amplificateur mélangeur selon la revendication 1, **caractérisé en ce que** l'étage d'amplification est réalisé sous la forme d'une paire de cellules (B1, B2) en parallèle, le filtre bouchon (B) étant disposé entre les deux cellules en parallèle.

**3.** Amplificateur mélangeur selon l'une des revendications 1 et 2, **caractérisé en ce que** le filtre bouchon (B) comporte des moyens (R3, R4, A) pour détecter un déséquilibre entre les deux cellules et une source de courant (T9) qui est connectée auxdites cellules et qui est pilotée par des moyens pour détecter le déséquilibre de manière à modifier le circuit circulant dans chaque cellule.

**4.** Amplificateur mélangeur selon la revendication 3, **caractérisé en ce que** la source de courant (T9) est raccordée à chaque cellule (B1, B2) par une inductance.

**5.** Amplificateur mélangeur selon la revendication 4, **caractérisé en ce que** le noeud commun entre la source de courant et les inductances est raccordé à la masse par un condensateur (C4).

**6.** Amplificateur mélangeur selon l'une quelconque des revendications 3 à 5, **caractérisé en ce que** les moyens pour détecter le déséquilibre comportent un comparateur (A) dont l'une des bornes inverseuse et non inverseuse reçoit un niveau de potentiel prélevé entre les deux cellules et dont l'autre borne reçoit un seuil de tension de détection de déséquilibre.

**7.** Amplificateur mélangeur selon la revendication 6, **caractérisé en ce que** les deux cellules étant reliées par une branche du circuit pourvue de deux résistances identiques (R3, R4), ledit niveau de tension est constitué par le point commun entre les deux résistances.

**8.** Amplificateur mélangeur selon l'une quelconque des revendications 1 à 7, **caractérisé en ce qu'**il est réalisé à partir d'une cellule de Gilbert.

**9.** Amplificateur mélangeur selon la revendication 8, **caractérisé en ce que** la cellule de Gilbert est une cellule de Gilbert doublement équilibrée.

**10.** Circuit frontal radiofréquence pour appareil de télécommunication, **caractérisé en ce qu'**il comporte un amplificateur mélangeur selon l'une quelconque des revendications 1 à 9.

Fig.1

Fig.2

**Office européen
des brevets**

**RAPPORT DE RECHERCHE EUROPEENNE**

Numéro de la demande

EP 07 11 0347

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2002/004376 A1 (S LEE) 10 janvier 2002 (2002-01-10) * alinéa [0004] - alinéa [0005]; figure 1 * * alinéa [0014]; figures 3,4 * * alinéa [0016]; figure 5 * ----- | 1-10 | INV. H03D7/14 |
| A | US 2004/227559 A1 (S ERBA) 18 novembre 2004 (2004-11-18) * alinéa [0006] - alinéa [0015] * * alinéa [0030] - alinéa [0050]; figure 1 * ----- | 1-10 | |
| A | US 2003/184366 A1 (A YOSHIDA) 2 octobre 2003 (2003-10-02) * alinéa [0044] - alinéa [0051]; figure 4 * ----- | 1-10 | |
| A | US 2003/112049 A1 (S WANG) 19 juin 2003 (2003-06-19) * figure 6 * ----- | 1-10 | DOMAINES TECHNIQUES RECHERCHES (IPC) H03D |

Le présent rapport a été établi pour toutes les revendications

| Lieu de la recherche | Date d'achèvement de la recherche | Examinateur |
|---|---|---|
| La Haye | 10 juillet 2007 | Butler, Nigel |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 07 11 0347

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-07-2007

| Document brevet cité au rapport de recherche | | Date de publication | Membre(s) de la famille de brevet(s) | | Date de publication |
|---|---|---|---|---|---|
| US 2002004376 | A1 | 10-01-2002 | KR | 20010000132 A | 05-01-2001 |
| US 2004227559 | A1 | 18-11-2004 | EP | 1450480 A1 | 25-08-2004 |
| US 2003184366 | A1 | 02-10-2003 | AUCUN | | |
| US 2003112049 | A1 | 19-06-2003 | AUCUN | | |

EPO FORM P0460

Pour tout renseignement concernant cette annexe : voir Journal Officiel de l'Office européen des brevets, No.12/82